Europäisches Patentamt

European Patent Office

Office européen des brevets

(19)

(11) Veröffentlichungsnummer : **0 030 520**
**B1**

(12) **EUROPÄISCHE PATENTSCHRIFT**

(45) Veröffentlichungstag der Patentschrift :
**05.10.83**

(51) Int. Cl.³ : **G 01 N 21/89**

(21) Anmeldenummer : **80810373.3**

(22) Anmeldetag : **01.12.80**

(54) **Verfahren und Vorrichtung zur Prüfung beschichteten Trägerbahnstoffes zum Erfassen von darauf vorhandenen Giesslinien.**

(30) Priorität : **07.12.79 GB 7942268**

(43) Veröffentlichungstag der Anmeldung :
**17.06.81 Patentblatt 81/24**

(45) Bekanntmachung des Hinweises auf die Patenterteilung : **05.10.83 Patentblatt 83/40**

(84) Benannte Vertragsstaaten :
**BE CH DE FR GB IT LI**

(56) Entgegenhaltungen :
**EP A 0 008 010**
**GB A 1 526 375**
**US A 4 005 281**
**US A 4 118 127**

**ELECTRONICS, Band 40, Nr. 14, 24. Juli 1967 NEW YORK (US) W. HARDEN : « Digital filters with IC's boost Q without inductors » Seiten 91-100**

**IEEE TRANSACTIONS ON CIRCUITS AND SYSTEMS, Band CAS-21, Nr. 3, Mai 1974 NEW YORK (US) H. WUPPER : « A modified N-patch filter suited for practical realization Seiten 449-456**

(73) Patentinhaber : **CIBA-GEIGY AG**
**Patentabteilung Postfach**
**CH-4002 Basel (CH)**

(72) Erfinder : **Neale, Denis Manktelow**
**49 Headley Chase**
**Brentwood Essex, CM14 5DH (GB)**
Erfinder : **Bontoft, Frederick John**
**10 Vale End Galleywood**
**Chelmsford Essex (GB)**
Erfinder : **Ikin, John Bruce**
**40 Marine Avenue**
**Leigh-on-Sea Essex (GB)**

## Verfahren und Vorrichtung zur Prüfung beschichteten Trägerbahnstoffes zum Erfassen von darauf vorhandenen Giesslinien

Die vorliegende Erfindung bezieht sich auf ein Verfahren und eine Vorrichtung zur Erkennung von Giesslinien auf einer beschichteten Trägerbahn gemäss den Oberbegriffen der Ansprüche 1 und 9.

Bei der Herstellung photographischer Filme und Papiere wird während der Beschichtung des Trägermaterials mit den silberhalogenidhaltigen Emulsionen ein Höchstmass an Gleichförmigkeit angestrebt. Insbesondere muss sehr sorgfältig darauf geachtet werden, dass sichergestellt wird, dass sich die durch die Beschichtungsvorrichtung aufgetragene Menge an Beschichtungslösung von Punkt zu Punkt über die beschichtete Breite der Trägerbahn hinweg um weniger als 2 % verändert. Bei Auftreten einer örtlichen Abweichung, die diese Grenze überschreitet, wird diese im photographischen Material nach Belichtung und Verarbeitung als ein der Länge nach auf der Bahn herablaufender Streifen sichtbar. Diese Streifen werden hiernach als « Giesslinien » bezeichnet.

Man hat erkannt, dass die Nachweisbarkeit einer Giesslinie mit der Länge der der Prüfung unterworfenen Bahn steigt. Zum Erkennen sehr feiner Giesslinien kann es daher unter Umständen erforderlich sein, eine beträchtliche Länge Bahn zu prüfen. Zwangsläufig wird dadurch das Anzeigen des Vorhandenseins einer solchen Giesslinie verzögert. Es ist trotzdem wichtig, dass sie erfasst wird, da ein Giesslinienfehler kaum jemals spontan von selbst wieder verschwindet, wenn er sich erst einmal durch Verschmutzung oder Beschädigung der Beschichtungsvorrichtung ausgebildet hat.

Das Erkennen von Giesslinien in Beschichtungen ist besonders schwierig während der Herstellung, und zwar aus folgenden verschiedenen Gründen :

1. Vor der chemischen Verarbeitung, der der Film bzw. das Papier ausgesetzt wird, ist die Sichtbarkeit einer Giesslinie viel geringer.

2. Da das Material für sichtbares Licht empfindlich ist, ist eine Sichtprüfung der neu beschichteten Trägerbahn ausgeschlossen oder muss auf eine derartig geringe Lichtstärke beschränkt werden, dass sie unwirksam ist.

3. Bei automatischer Prüfung wird das Produkt allgemein Punkt für Punkt untersucht. Eine etwaig vorhandene Giesslinie wird dann oft durch zufällige örtliche Veränderungen der optischen Eigenschaften aufgrund der Bahnstruktur und der Schichtmaserung der Sicht entzogen. Diese unregelmässigen Veränderungen können in einem Produkt annehmbar sein, während eine Giesslinie meistens nicht annehmbar ist.

Es besteht daher ein Bedarf für ein Verfahren, beschichtete Trägerbahnen so zu untersuchen, dass Giesslinien selbst sehr grosser Feinheit erkannt werden können.

Zur Erfüllung dieses Erfordernisses sind verschiedene Versuche unternommen worden, die jedoch bislang alle nur von begrenztem Erfolg begleitet waren, da das Fehlersignal in Gegenwart von Störsignalen von der Bahnstruktur, der Schichtmaserung und Elektronenrauschen im Prüfgerät nicht leicht erfassbar ist. Wenn man die Ansprechempfindlichkeit auf Fehlersignale erhöht, werden mit erhöhter Wahrscheinlichkeit als Reaktion auf Störsignale Falschanzeigen erstellt. Mit zeitlichem Filtern kann oft wenig bewirkt werden, um die beiden auseinander zu trennen, da die betroffenen Frequenzbänder überlappen.

Es ist aus der Praxis bekannt, die Trägerbahn periodisch wiederkehrend und querlaufend mit einem mit optischen Mitteln in Bahnbewegungsrichtung verlängerten Strahl abzutasten. Wenn beispielsweise der Strahl daher auf einen Querschnitt mit einem Länge-zu-Breite-Verhältnis von 10 zu 1 ausgedehnt wird, liefert eine reflektiertes bzw. durchgelassenes Licht empfangende Photozelle bei jeder einzelnen Abtastung eine Stromwellenform, die einer durch Durchschnittsbildung der Signale von 10 Abtastungen erzeugten gleicht, die mit einem Strahl quadratischen Querschnitts gleicher Breite durchgeführt und so angeordnet werden, dass aufeinanderfolgende Abtastungen aneinandergrenzen und einander nicht überlappen.

In der Praxis wird der Wert einer solchen Strahlverlängerung durch folgende Faktoren eingeschränkt :

1. Die Oberflächenstruktur der Trägerbahn bzw. die Maserung der Beschichtung ist im Vergleich zur Breite des Abtaststrahls allgemein grob. Infolgedessen besteht zwischen der bei einer Abtastung mit einem Strahl kreisförmigen oder quadratischen Querschnitts untersuchten Bahnflächenstruktur und -maserung und der bei der nächsten untersuchten ein hohes Mass an Korrelation. Die von der Oberflächenstruktur bzw. -maserung hervorgerufenen Störkomponenten sind daher nicht unabhängig voneinander und Durchschnittsbildung einiger aufeinanderfolgender Abtastungen (z. B. durch Strahlverlängerung) kann nur eine begrenzte Verbesserung bieten.

2. Beim Gebrauch eines stark verlängerten Prüfungsstrahls ergeben sich grosse Schwierigkeiten praktischer Natur. Es würde beispielsweise problematisch sein, einen Prüfungsstrahl mit einer Querschnittslänge von 10 Metern und einer Breite von ca. 0,1 mm mit hinreichend guter Winkelausrichtung zur Bahnrichtung zu liefern und aufrecht zu erhalten. Bei einem derartigen Strahl müssten die Winkelausrichtungsfehler weniger als $1 \cdot 10^{-5}$ betragen.

3. Es gibt keine Abschwächung des Rauschens, das den Abtaststrahl modulieren kann, ehe er auf die Bahn auftritt, und auch nicht des in der Photozelle erzeugten Schrotrauschens.

4. Es ist häufig erforderlich, neben Strichen in der Beschichtung das Vorhandensein kleiner Punkte und Nadellöcher in der Bahn oder ihrer Beschichtung zu erfassen. Durch Verlängerung der Querschnittslänge des Abtaststrahles auf etwa das Zehnfache seiner Breite wird das Verhältnis, mit dem der Photozellenstrom sich verändert, wenn ein kreisförmiger Defekt mit einem der Abtaststrahlbreite gleichen Durchmesser überquert wird, um den Faktor 10 verringert. Eine Strahlverlängerung an sich führt jedoch nicht zu einer entsprechenden Verringerung in der Höhe des das Signal begleitenden Rauschens.

Hinsichtlich der Erkennung von Punktmängeln wird daher jegliche Verlängerung des Querschnitts des Abtaststrahls von einer Herabsetzung des Rauschabstandes begleitet.

Beim Stand der Technik sind Verfahren ersonnen worden, mit denen man versucht, die oben angeführten Beschränkungen zu überwinden. Diese Verfahren stützten sich auf die elektronische Verarbeitung von Signalen, die durch Abtasten der Trägerbahn mit einem Strahl kreisförmigen öder mässig verlängerten Querschnitts erhalten wurden. Die bekannten Verfahren beruhen auf Erfassung von Koinzidenzen in der Lage verdächtiger Fehlersignale, die erzeugt werden, wenn die Bahn wiederholt quer zur Bahnlaufrichtung untersucht wird.

Bei einem solchen System wird beispielsweise mittels jeden verdächtigen Fehlersignals während der darauffolgenden Untersuchung ein elektronisches Gatter geöffnet. Das Gatter wird vor Erreichen der voraussichtlichen Lage des Fehlers geöffnet und nach ihrem Vorbeilaufen geschlossen. Wenn ein Signal erfasst wird, während das Gatter offen ist, wird in einem Zähler eine Zählung registriert. Nachdem bei aufeinanderfolgenden Prüfungen eine vorgegebene Anzahl Zählungen aufgespeichert worden ist, wird das Vorhandensein der Giesslinie als bestätigt angesehen und ihre Lage kann aufgezeichnet werden. Dieses System kann beim Verhindern von Falschanzeigen aufgrund von Störsignalen wirksam sein ; wenn aber die Anprechempfindlichkeit zu weit erhöht wird, können Störsignale Fehlersignale bei Einzelprüfungen aufheben oder verdecken und die vorbestimmte Zählung wird daher nie erreicht.

Wenn in einem Versuch, dieses Problem zu umgehen, für die vorbestimmte Zählung eine niedrigere Zahl gewählt wird, besteht grössere Gefahr, dass durch Störsignale, die bei aufeinanderfolgenden Untersuchungen mit der Oeffnungszeit des elektronischen Gatters zusammenfallen, eine Falschanzeige einer Giesslinie erzeugt wird.

In einem Versuch, diese Gefahr zu überwinden, wird bei einem bekannten Gerät ein zweistufiges System eingesetzt. Wie bereits beschrieben, werden elektronische Gatter und Zähler dazu verwendet, die Lagen von möglichen Giesslinien zu identifizieren. Jedesmal, wenn ein sogenannter Primärzähler einen vorbestimmten Zählstand erreicht, wird einem sogenannten Sekundärzähler ein Impuls zugeführt. Wenn der Sekundärzähler innerhalb einer vorgeschriebenen Zeit eine entsprechende Anzahl Impulse erhält, wir eine Giesslinie verzeichnet. Die erzielte Verbesserung beruht auf dem Vermögen dieses zweistufigen Systems, die Lage eines Striches zu identifizieren, dessen Grösse nahe bei der der begleitenden Störsignale liegt und gelegentlich durch sie verdeckt wird.

Alle genannten Systeme der Giesslinienerfassung leiden an der Einschränkung, dass sie bei Einzelprüfungen ein Fehlersignal benötigen, dass merklich grösser als die begleitenden Störsignale sein muss. Da Störsignale unbestimmte Grösse besitzen, hängt die Höchstempfindlichkeit, auf die der Detektor eingestellt werden kann, von der duldbaren Anzahl Falschanzeigen ab. Selbst bei dem eben beschriebenen zweistufigen System ist jedoch eine zuverlässige Erfassung einer Giesslinie nicht durchführbar, wenn die Höhe des Fehlersignals unter ca. der halben Spitzenhöhe der begleitenden Störsignale liegt.

Es scheint jedoch, dass der bisher genannte Stand der Technik die einer Giesslinie eigenen Eigenschaften unzureichend nutzt. Eine dieser Eigenschaften besteht beispielsweise darin, dass eine Giesslinie in einem 1 Quadratmeter grossen Bogen beschichteten Papiers deutlich sichtbar sein kann, obwohl sie in einem quer zur Giesslinienrichtung herausgeschnittenen, 1 cm grossen Streifen unsichtbar ist. Das kommt daher, dass die Oberflächenstruktur des Papiers optische Informationen bietet, die das Vorhandensein eines feinen Strichfehlers verdecken. Bei der Betrachtung des 1 Quadratmeter grossen Bogens kann das Gehirn des Betrachters jedoch in den Informationen der Oberflächenstruktur eine Wechselbeziehung entdecken, die das Vorhandensein des Strichfehlers verrät.

Zum Erfassen von sehr feinen Giesslinien ist es daher von Wichtigkeit, so weit wie durchführbar alle Daten zu nutzen, die sowohl über die Bahnbreite und die untersuchte Länge hinunter zur Verfügung stehen. Ein gewisser Fortschritt in dieser Richtung wurde bereits durch die z. B. in der GB-A-1 526 375 beschriebene Vorrichtung erreicht. Bei dieser Vorrichtung werden die Abtastsignale von jeweils einer Anzahl von Zeilenabtastpunkten, die in jeweils in Bewegungsrichtung der Bahn verlaufenden Abtastspuren aufeinanderfolgen, akkumuliert und die dabei für jede Abtastspur getrennt akkumulierten Abtastwerte mit einem Schwellenwert verglichen, bei Ueberschreitung von welchem eine Giesslinie für die betreffende Abtastspur signalisiert wird. Als Schwellenwert wird dabei der akkumulierte Abtastwert aus einer benachbarten Abtastspur oder der Mittelwert aus mehreren benachbarten oder überhaupt allen Abtastspuren zusammen verwendet. Diese in der GB-A-1 526 375 beschriebene Vorrichtung arbeitet zwar im grossen und ganzen zufriedenstellend, ist jedoch noch verbesserungsfähig und vor allem sehr aufwendig.

Durch die Erfindung sollen nun ein Verfahren und eine Vorrichtung der eingangs definierten und in der GB-A-1 526 375 beschriebenen Art verbessert werden, sodass einerseits die zur Ver-

füging stehenden Daten in grösstem Masse zur Erkennung von Giesslinien ausgenützt werden und anderseits dazu ein verhältnismässig nur geringer apparativer Aufwand erforderlich ist. Das erfindungsgemässe Verfahren und die Vorrichtung sind durch die in den Ansprüchen 1 und 9 angeführten Massnahmen gekennzeichnet. Bevorzugte Ausführungsformen sind in den abhängigen Ansprüchen beschrieben.

Es werden nunmehr praktische Ausführungsformen der Erfindung näher beschrieben unter Bezugnahme auf die beigefügten Zeichnungen. Es zeigen :

Figur 1 einen typischen Lichtpunkt-Laserabtaster für Trägerbahnprüfung gemäss dem Stand der Technik,

Figuren 2A-4d verschiedene charakteristische Signale, wie sie bei der Abtastung einer Trägerbahn entstehen,

Figur 5 ein Blockschema des erfindungsgemässen Verfahrens,

Figur 6a und 6b zwei Formen eines Kammfilters,

Figur 7 eine rekursive Laufzeitkette,

Figur 8 ein Blockschema einer Variante einer zur Durchführung des Verfahrens geeigneten Vorrichtung,

Figur 9 und 10 schematische Uebersichten über Abtastpositionen, und

Figur 11 ein Blockschema einer weiteren Vorrichtung nach der Erfindung.

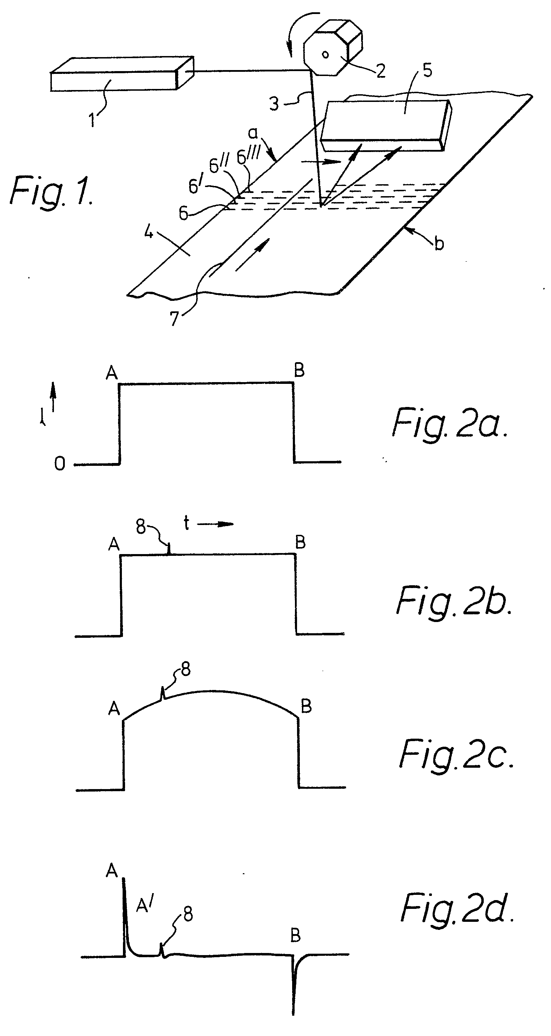

In Figur 1 projiziert ein Laser 1 einen Lichtstrahl so auf ein rotierendes Spiegelpolygon 2, dass der reflektierte Strahl 3 auf eine laufende Trägerbahn 4 fällt und quer über diese läuft. Von der Bahn reflektiertes Licht wird von einer Photozelle im Gehäuse 5 empfangen und ruft elektrische Signale hervor, die ein Mass für das Reflexionsvermögen der Bahn und dessen Gleichformigkeit sind. Wenn die Bahn kontinuierlich an der Prüfstation vorbeibewegt wird, die den Laser 1, das Polygon 2 und das Photozellengehäuse 5 umfasst, wird die Bahn durch die wiederholte Querbewegung des Strahls 3 über ein Raster paralleler, in Figur 1 durch gestrichelte Linien, 6, 6', 6", 6''' usw. dargestellter Querpfade untersucht. Im Idealfall würde die Untersuchung einer perfekt gleichförmig beschichteten Bahn bei der Photozelle für jede Querprüfung der Bahn ein elektrisches Signal hervorrufen, das sich wie in Figur 2a mit der Zeit verändert. In Figur 2a wird der Photozellenstrom i als Null gezeigt, während der Strahl 3 über den Rand der Bahn 4 hinaus abgelenkt ist. Wenn der Strahl 3 auf den Rand a der Bahn auftrifft, bewirkt das von der Bahn reflektierte Licht, dass der Photozellenstrom auf einen vom Bahnreflexionsvermögen abhängigen Pegel ansteigt. Der Photozellenstrom bleibt auf diesem Pegel, durch Linie AB in Figur 2a dargestellt, bis der Strahl 3 die Bahn 4 am Rand b verlässt. Danach fällt der Photozellenstrom abrupt auf Null ab.

Bei seiner Bewegung über die Bahn 4 kann der Strahl 3 auf eine Giesslinie 7 treffen, deren Reflexionsvermögen über dem Mittelwert für den Trägerbahnstoff liegt. Entlang der Giesslinie kann die Beschichtung beispielsweise dünn oder abwesend sein. In einem solchen Fall würde das elektrische Signal in Figur 2a zu einer Form verändert werden, wie sie in Figur 2b gezeigt wird. In Figur 2b ist der positiv verlaufende Impuls 8 im Photozellenstrom die Folge des momentanen Anstieges im Strom von der Photozelle, während der Strahl 3 auf die Giesslinie 7 fällt. Der Impuls 8 wird leicht durch eine elektrische Triggerschaltung als Abweichung von dem zwischen Punkten A und B hergestellten Signalpegel erfasst.

In einem praktischen System würde die Linie AB wahrscheinlich wie in Figur 2c gezeigt gebogen sein aufgrund fortschreitender Veränderungen im Wirkungsgrad des Sammelns reflektierten Lichtes durch die Photozelle beim Überstreichen der Bahn durch den Strahl 3. Der schmale Impuls 8 ist jedoch leicht durch zeitliche Filterung von solchen relativ langsamen Veränderungen im Photozellenstrom zu unterscheiden. Während die Biegung der Linie AB nur der Grundwelle und niedrigwertigen Oberwellen der Frequenz des Abtastens der Bahn 4 durch den Strahl 3 entspricht, enthält der Impuls 8 beträchtliche Energie in den höherwertigen Oberwellen dieser Frequenz. Es kann daher durch Filterung des Signals zum Entfernen aller efwa der zehnten Oberwelle und darunter entsprechenden Frequenzen eine Wellenform nach Figur 2d erzielt werden. Der Impuls 8 kann dann leicht durch eine Triggerschaltung erfasst werden, vorausgesetzt der Trigger wird so angesteuert, dass er nur zwischen den Punkten $A^1$ und B in Figur 2d aktiv ist, wodurch vorübergehende durch Überquerung der Bahnränder a und b durch den Strahl 3 erzeugte Signale ausgeschlossen werden.

Das Vorangehende ist dem Fachmann in Trägerbahnprüfsystemen gut bekannt. Auch ist es wohlbekannt, dass in einem praktischen Fall die Ansprechempfindlichkeit, auf die die Triggerschaltung eingestellt werden kann, durch das Systemrauschen begrenzt ist. Dieses Rauschen entsteht aus annehmbaren Ungleichförmigkeiten in der Bahnoberfläche, Störungen im Laserstrahl und Elektronenrauschen in der Photozelle. Wenn lichtempfindliche Stoffe untersucht werden müssen, muss die im Strahl 3 enthaltene Energie eingeschränkt werden, um eine wesentliche Belichtung des Stoffes zu vermeiden. Diese Beschränkung der Strahlenergie bedeutet, dass der Photozellenstrom nur gering sein kann und das Elektronenrauschen vergleichsweise hoch liegt. In der Praxis sind den in Figuren 2a-2d gezeigten Wellenformen daher verschiedene Rauschkomponenten überlagert, und Erfassung eines Impulses 8 wird schwierig.

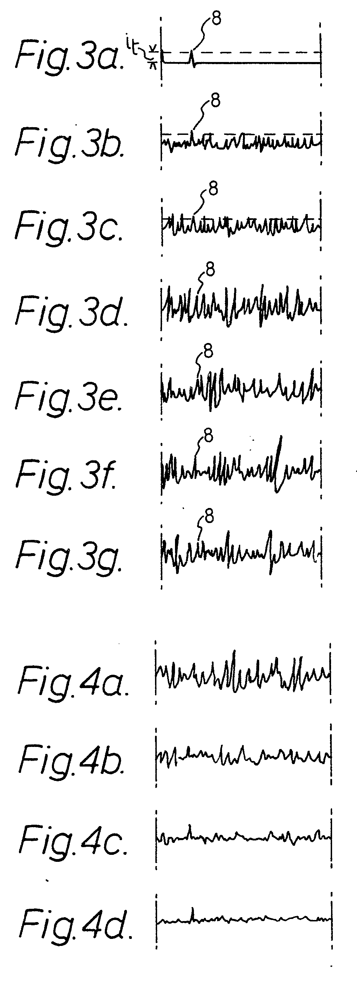

In Figur 3a wird der dem Abschnitt A'B in Figur 2d entsprechende Teil eines rauschfreien Signals gezeigt. Der Impuls 8 wird leicht durch eine elektrische Triggerschaltung erfasst, die so eingestellt ist, dass sie die Amplitude $i_t$ überschreitende Stromimpulse erfasst. Wenn zu der Signalwellenform eine geringe Menge Rauschen hinzugefügt wird, nach Figur 3b, ist der Impuls 8 immer noch leicht erfassbar, vorausgesetzt die Amplitude des Impulses 8 ist höher als die Amplitude von Rauschabweichungen.

Bei höherer Rauschamplitude, nach Figur 3c, ist die Amplitude des Impulses 8 höher als die meisten aber nicht alle Rauschabweichungen. Verfahren zur Behandlung dieses Problems nach dem Stand der Technik wurden oben beschrieben. Diese beruhen auf Anwendung einer Triggerempfindlichkeit, die zum Erfassen des Impulses 8 bei einem einzelnen Querabtasten durch den Strahl 3 ausreicht. Eine derartig hohe Ansprechempfindlichkeit führt dazu, dass der Trigger durch Rauschspitzen mit einer der des Impulses 8 gleichenden bzw. diese überschreitenden Amplitude ausgelöst wird. Ein Vergleich wird angestellt zwischen den Stellen entlang dem Abtastweg, bei denen bei aufeinanderfolgenden Abtastungen eine Triggerauslösung eintritt. Diejenigen Stellen, die für eine vorbestimmte Anzahl Abtastungen zusammenfallen, werden als Giesslinien angesehen.

In Figur 3d hat das überlagerte Rauschen eine noch höhere Amplitude. In diesem Fall hat der Impuls eine geringere Amplitude als der Hauptteil der Rauschspitzen und bei vielen Abtastungen wird der positiv verlaufende Impuls 8 durch zufälliges Zusammentreffen mit einer negativ verlaufenden Rauschspitze aufgehoben oder umgekehrt. Unter den durch Figur 3d dargestellten Umständen verringern solche zufällige Zusammentreffen die Wahrscheinlichkeit, dass die Triggerschaltung bei einer bestimmten Abtastung als Reaktion auf den Impuls 8 ausgelöst wird. Andererseits erhöht sich die Wahrscheinlichkeit, dass bei aufeinanderfolgenden Abtastungen die Auslösestellungen durch Rauschspitzen mit einer Amplitude, die über der des Impulses 8 liegt, in bedeutendem Masse zusammentreffen. Stricherkennungsverfahren gemäss dem oben genannten Stand der Technik werden daher unzuverlässig, wenn das Systemrauschen die Amplitude des zu erfassenden Signals sehr stark übersteigt.

Bei dem Verfahren gemäss der vorliegenden Erfindung wird kein Versuch gemacht, das Fehlersignal vom Rauschen zu unterscheiden, ehe die Signale von einer grossen Anzahl Abtastungen zusammengefasst worden sind. Unter Bezugnahme auf Figuren 3d-3g ist ersichtlich, dass bei aufeinanderfolgenden Abtastungen quer über die sich bewegende Bahn 4 die Amplitude und Phase des Fehlersignals 8 immer gleich ist. Die momentane Amplitude der Rauschkomponenten ist jedoch unvorhersehbar und liegt manchmal über und manchmal unter dem durch die Wellenform in Figur 3a dargestellten Durchschnittspegel. Demnach werden die Rauschkomponenten dazu neigen, sich gegenseitig aufzuheben, wenn vier oder mehr Wellenformen von Punkt zu Punkt entlang dem Abtastweg zusammengefasst werden, die Fehlersignale 8 jedoch verstärken einander. Dieses Verfahren, als « Summierung » bzw. « Mittelung des Ganzen »

bekannt, ist ein bekanntes Verfahren zur Wiedergewinnung von im Rauschen untergegangenen Signalen, und es wird bei der Durchführung des Verfahrens der vorliegenden Erfindung angewandt. Wenn Signale durch Summierung vereinigt werden, erhöht sich die Amplitude des gesuchten Impulses im Verhältnis zur Anzahl der vereinigten Signale. Wenn Signale durch Mitteln vereinigt werden, verringert sich die Amplitude der zufälligen Rauschkomponente im Verhältnis zur Quadratwurzel der Anzahl der vereinigten Signale. Durch Zusammenfassung einer hinreichend grossen Anzahl Abtastwellenformen wird die Rauschkomponente daher auf einen brauchbar niedrigen Bruchteil der Amplitude des Fehlersignals reduziert. Wie bereits unter Bezugnahme auf Figuren 3a und 3b beschrieben, lässt sich danach das Fehlersignal leicht erfassen. Die Wirkung der Mittelung des Ganzen wird in Figuren 4a-4d angezeigt. In Figur 4a ist das Fehlersignal 8 im Rauschen untergetaucht, d. h. das Verhältnis Signalstrom zu Rauschstrom ist Kleiner als Eins. Durch Zusammenfassung der Signale von vier getrennten Abtastungen der Bahn wird der Rauschabstand verdoppelt, wie in Figur 4b gezeigt. Die Figuren 4c und 4d zeigen die weiteren Verdoppelungen des Rauschabstandes, die sich durch Zusammenfassung der Signale von 16 bzw. 64 Abtastungen erzielen lassen. Mittelung des Ganzen ist ein besonders leistungsfähiges Signalverarbeitungsverfahren, da es keine theoretische Grenze dafür gibt, wievielmal man den Rauschabstand verdoppeln kann, indem man einfach jedesmal die Anzahl der einzelnen Abtastungen vervierfacht und die Signale von diesen vereinigt.

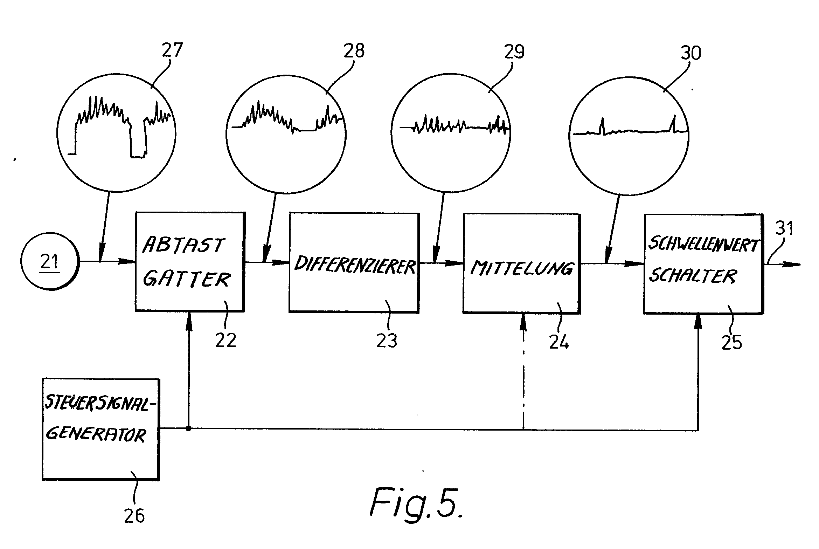

Figur 5 zeigt, wie sich eine Schaltung zur Mittelung des Ganzen bei einem Trägerbahnprüfsystem einsetzen lässt. In Figur 5 empfängt die Photozelle 21 von der Bahn ausgesandtes bzw. reflektiertes Licht. Der von der Photozelle erzeugte Strom besitzt eine im wesentlichen periodische Wellenform, bei 27 eingefügt dargestellt, die der Figur 2c entspricht unter Beifügung von willkürlich verteilten Rauschkomponenten. Ein Steuerwellenformgenerator 26 ist mit dem Bahnabtastvorgang synchronisiert und führt dem Abtastgatter 22 Ansteuersignale zu, die bewirken, dass das Gatter 22 Wellenformstörungen ausschliesst, die vom Überqueren der (hier nicht gezeigten) Bahnränder durch den Abtaststrahl herrühren. Wenn daher am Ende eines Abtastvorgangs der Abtaststrahl sich dem Bahnrand b nähert (Figur 1), wird der Signalpegel konstant gehalten, bis der Strahl den Rand a zu Beginn des nächsten Abtastvorgangs überschritten hat. Die im Nebenbild 28 gezeigte veränderte Signalwellenform geht als nächstes zum Differenzierer 23. Der Differenzierer ist im wesentlichen ein Hochpassfilter, der Komponenten mit der Abtastfrequenz $f_s$ und deren Oberwellen bis etwa zur zehnten Oberwelle beseitigt. Der Differenzierer 23 kann gewohlich auch sehr hohe Frequenzen abschwächen, d. h. Frequenzen mit $1\,000 \cdot f_s$ oder darüber. In diesem Fall kann der Differenzierer 23 als Bandpassfilter mit einem Durchlassbereich von ca. 10 $f_s$ bis 1 000 $f_s$ bezeichnet werden.

Nach Differenzierung ist die Signalwellenform im wesentlichen wie im Nebenbild 29 gezeigt. Der von einem Längsstrich herrührende Impuls kann immer noch durch Rauschkomponentenverdeckt sein. Die Schaltung 24 zur Mittelung des Ganzen empfängt die bei 29 gezeigte Wellenform und gibt nach Empfang von vielen Abtastvorgängen entsprechenden Signalen die bei 30 gezeigte Ausgangswellenform ab. Die von einer Giesslinie herrührenden Impulse sind jetzt deutlich unterscheidbar von den Rauschkomponenten, da die letzteren beinahe auf Null gemittelt worden sind. Die Wellenform 30 wird an eine Triggerschaltung 25 zur Erfassung der Hauptauslenkungen der Wellenform 30 angelegt. Es kann wünschenswert sein, den Steuerwellenformgenerator 26 die Triggerschaltung so ansteuern zu lassen, das eine Auslösung nur als Reaktion auf Signalstörungen stattfindet, die während des aktiven Teils des Abtastvorgangs, d. h. zwischen Überquerung des Bahnrandes *a* und Verlassen des Bahnrandes *b* in Figur 1 erzeugt werden. Die Ausgangsleitung 31 von der Triggerschaltung kann dazu benutzt werden, einen Alarm auszulösen, wenn eine Giesslinie erkannt wird bzw. um ihre Lage auf der Bahn anzuzeigen.

Nach dieser Beschreibung der Einsatzmöglichkeit für Mittelung bei der Trägerbahnprüfung werden alternative Ausführungsweisen für den Vorgang der Mittelung des Ganzen unter Verwendung des Verfahrens der vorliegenden Erfindung zum Erzielen von Einsparungen im zugehörigen Gerät angegeben.

Bei einer Fourier-Analyse der in Figuren 3d-3g dargestellten periodischen Wellenformen ist festzustellen, dass das Fehlersignal 8 ein Spektrum fester Frequenzen hervorruft, die der Abtastfrequenz $f_s$ und ihren ganzzahligen Oberwellen entsprechen. Bei schmalen Giesslinien werden die damit verbundenen Oberwellen höherwertig, und ein aperiodischer Signalverstärker mit ausreichendem Durchlassbereich wird ein unerwünscht breites Band Rauschsignale annehmen. Durch Filtern des Signalgemischs, so dass nur die Abtastfrequenz und ihre Oberwellen mit jeweils sehr schmaler Bandbreite durchgelassen werden, lässt sich jedoch die Gesamtbandbreite des Systems stark reduzieren. Das bedeutet, dass die Energie von Rauschsignalen entsprechend reduziert wird, ohne die Energie in den gewünschten Fehlersignalen abzuschwächen. Auf diese Weise lässt sich der Rauschabstand auf grösser als Eins erhöhen, so dass Fehlersignale sicher erkennbar sind, obwohl sie anfangs von Rauschsignalen mit viel höherer Amplitude begleitet sind.

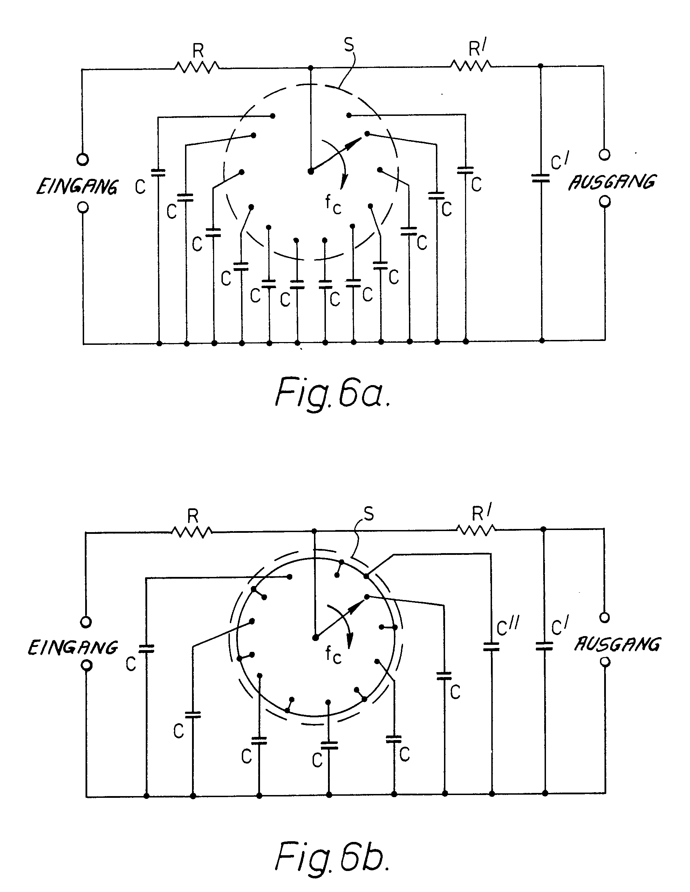

Um diese schmale Bandbreite zu erreichen, muss das Filter irgendeine Form von Energiespeicher mit sehr niedrigem Energieverlust enthalten. Die dem Filter zugeführte Energie wird summiert, wenn die Eingangssignale mit den harmonisch miteinander verknüpften Frequenzen stets phasengleich anliegen. Mit diesen Frequenzen zusammenfallende Rauschkomponenten haben willkürlich verteilte Phasenlagen und neigen daher dazu, sich gegenseitig über den Zeitraum vieler Bahnprüfungen hinweg aufzuheben. Ein Filter, der für selektives Durchlassen bzw. Blockieren einer bekannten Signalfrequenz und ihrer Oberwellen ausgelegt ist, wird Kammfilter genannt. In den Figuren 6a und 6b werden zwei Formen eines solchen Filters gezeigt. Diese Filterart wird auch Sampling-Filter genannt. Es ist leicht imstande, sehr hohe Gütefaktor-Werte zu liefern, und die übertragbare Höhe von Oberwellenfrequenzen ist lediglich durch Erwägungen praktischer Eignung begrenzt. Es lässt sich daher vorteilhaft als die Schaltung 24 zur Mittelung des Ganzen in Figur 5 einsetzen. Diese Art Filter ist im Einzelnen von W. R. Harden beschrieben worden (« Electronics », 24 Juli 1967, Seiten 91-100).

Wie in den Figuren 6a und 6b dargestellt, wird eine Kammfilterform mit hohem Gütefaktor dadurch hergestellt, dass N alternative Kondensatoren zyklisch in einen einfachen Tiefpassfilter eingeschaltet werden. Wenn der Schaltarm mit der Frequenz, $f_c$ rotiert, liefert das Filter Durchlassbereiche auf Null frequenz $f_c$ und Oberwellen von $f_c$.

Mit beliebigem angeschlossenen Kondensator kann das Tiefpassfilter als Integrator mit der Zeitkonstante $\tau = CR$ angesehen werden. Da jedoch jeder Kondensator sich nur für 1/N des Zyklus im Stromkreis befindet, wird die Spannung jedes Kondensators effektiv mit einer Zeitkonstante $\tau' = NCR$ aufgeladen.

Wenn an das Filter ein Eingangssignal mit der Frequenz $f_c$ bzw. mit einer Oberwelle von $f_c$ angelegt wird, wird jeder einzelne Kondensator jedesmal, wenn er in den Stromkreis geschaltet wird, mit demselben Signalabschnitt verbunden. Die Spannung an jedem Kondensator nähert sich daher dem Mittelwert dieses Signalabschnitts mit einer durch die Filterzeitkonstante $\tau'$ bestimmten Geschwindigkeit.

Rauschkomponenten mit nicht harmonisch mit $f_c$ verknüpften Frequenzen sind nicht synchron zum Schaltvorgang. Sie neigen infolgedessen dazu, einen Kondensator in einem Zyklus aufzuladen und ihn im nächsten wieder zu entladen. Wenn NCR gross genug gemacht wird, bietet sich ein hohes Mass an Schutz gegen Rauschen. Jeder Durchlassbereich des Filters hat, wenn seine Mittenfrequenz $n \cdot f_c$ ist, 3-dB-Punkte bei $n \cdot f_c \pm 1/(2 \pi NCR)$. Bei jedem Durchlassbereich ist der effektive Gütefaktor daher $n \cdot f_c \pi NCR$, wobei n die Ordnung der Oberwelle ist.

Das Ausgangssignal von einem Sampling-Filter nähert sich der komplexen zyklischen Eingangswellenform in einer Folge von N Schritten. Das Ausgangssignal enthält daher unerwünschte Komponenten mit der Frequenz $Nf_c$ und ungeradzahlige Oberwellen derselben. Diese sind leicht entfernbar durch ein weiteres Tiefpassfilter R'C' in Figuren 6a und 6b.

Die Amplituden, mit denen die Frequenzen $f_c$, $2f_c$, ... $nf_c$ übertragen werden, werden durch den Wert des Übertragungskoeffizienten $A_n$ zur jeweiligen Frequenz gegeben, wobei

$$A_n = \sin (n\pi/N)/(n\pi/N)$$

Hieraus ist ersichtlich, dass, wenn sich $A_n$ bei hohen Werten von n Eins nähern soll, $N > 4n$ gemacht werden muss. Eine praktische Erwägung kann daher sein, dass eine sehr grosse Anzahl N Kondensatoren benötigt wird, wenn Oberwellen bis etwa zur Hundertsten übertragen werden sollen. Harden beschreibt eine Version dieses Filters mit Festkörperschalten. Bei Einsatz von integrierten Schaltungen bereitet das Vorsehen und Schalten von vielen Kondensatoren keine ernsthaften Schwierigkeiten. $f_c$ wird vorzugsweise $f_s$ gleichgemacht, wobei aber der Aufwand wesentlich steigt, wenn sehr schmale Striche in der Bahnbeschichtung zu erfassen sind.

Wenn es beispielsweise erforderlich ist, 0,5 mm breite Striche zu erfassen, die irgendwo auf einer 1,5 m breiten Bahn vorkommen können, müsste der benötigte N-Wert nach dem bekannten Verfahren von Figur 6a mindestens $1500 : 0,5 = 3000$ betragen. Gemäss einer bevorzugten, noch näher zu erläuternden Ausführungsform der Erfindung jedoch kann eine geringere Anzahl Kondensatoren benutzt werden, z. B. 1 500, vorausgesetzt, dass jeder für nicht länger als 1/3 000 der Periode der komplexen zyklischen Eingangswellenform in den Stromkreis geschaltet wird. Die 1 500 Kondensatoren werden einzeln mit den 1., 3., 5., 7. usw. Stellungen des Schalters S verbunden. Die Zwischenstellungen (2., 4., 6., 8. usw.) werden zusammengeschlossen und mit einem einzigen Kondensator C" verbunden, wie in Figur 6b gezeigt. Im Betrieb wird der Arm des Schalters S mit der Frequenz $f_s$ rotiert, bis ausreichend Daten gesammelt worden sind, um feststellen zu können, ob ein von einem Beschichtungsstrich herrührendes Signal einem der 1 500 Kondensatoren zugeführt worden ist. Danach lässt man den Schaltarm mit der Frequenz $f_s$ rotieren, aber mit einer Phasenbeziehung zu der komplexen zyklischen Eingangswellenform, die zeitlich um 1/3 000 der Periode dieser Wellenform verschoben ist. Man lässt wiederum genügend Zeit verstreichen, damit sich ausreichend Daten ansammeln können, die anzeigen, ob in dieser alternativen Phasenbeziehung ein von einem Beschichtungsstrich herrührendes Signal erkannt werden kann. Danach kehrt der Betrieb des Schaltarms S wieder zur ursprünglichen Phasenbeziehung zurück. Der Betrieb kann unbegrenzt mit wechselweiser Verwendung der beiden Phasenbeziehungen weiterlaufen.

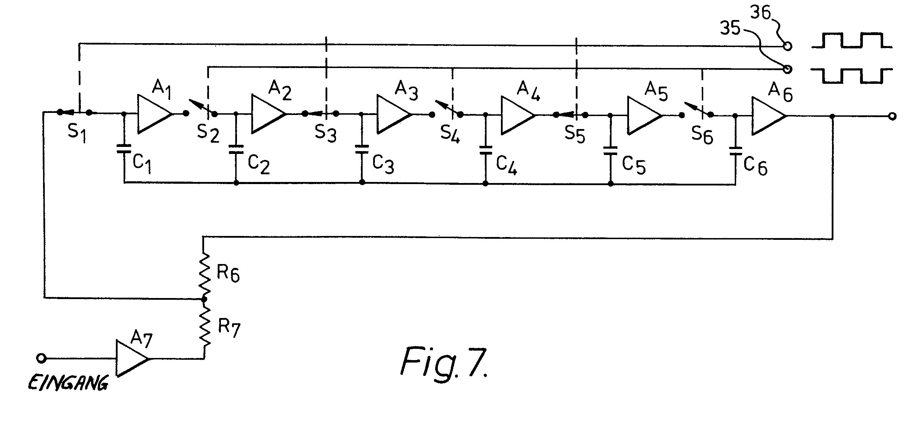

Eine weitere Art, eine Schaltung zur Mittelung des Ganzen vorzusehen, wird in Figur 7 gezeigt. Eine Anzahl M Kondensatoren, hier als $C_1$-$C_6$ dargestellt, werden an die entsprechenden Eingänge von Verstärkern $A_1$-$A_6$ mit Verstärkungsfaktor 1 angeschlossen. Die Schalter $S_1$-$S_6$ sind so angeordnet, dass jeder Kondensator mit dem Ausgang des dem vorangehenden Kondensator zugehörigen Verstärkers verbunden werden kann. Wenn $S_3$ wie gezeigt geschlossen ist, wird die Spannung an $C_3$ daher der an $C_2$ gleich. Alle ungeradzahligen Schalter schliessen und öffnen sich zusammen und in synchroner Gegenphase zum Öffnen und Schliessen der geradzahligen Schalter. So kann eine Reihe von M Kondensatoren bis zu M/2 Analogspannungen speichern, die in einem Muster angeordnet sind, das jedes Mal, wenn die Schalter einen Zyklus ihrer gegenphasigen Schalttätigkeit vollenden, um zwei Kondensatorstellungen nach rechts in Figur 7 rückt.

Die Reihe Kondensatoren wird durch Rückverkoppelung des Ausgangs von $A_6$ mit dem Schalter $S_1$ rekursiv gemacht. Ein das rechte Ende der Reihe verlassendes Spannungsmuster wird dann links wieder eingeführt.

Ein den Verstärker $A_7$ durchlaufendes Eingangssignal kann mit dem vom Verstärker $A_6$ abgegebenen Signal kombiniert werden. Die Widerstände $R_6$ und $R_7$ sind so dimensioniert, dass $R_7 \gg T_6$. Infolgedessen wird bei geschlossenem $S_1$ das von $C_1$ angenommene Potential hauptsächlich durch das Ausgangssignal von $A_6$ und nur zum geringen Teil vom Ausgangssignal von $A_7$ bestimmt.

Im Einsatz als Schaltung 24 zur Mittelung des Ganzen nach Figur 5 werden die Schalter zyklisch mit einer Taktfrequenz $f_r$ betrieben, die so ausgewählt ist, dass $f_r = M \cdot f_s$. Wenn die untersuchte Bahn eine Giesslinie enthält, wird an den Eingang von $A_7$ ein Signalimpuls angelegt, der stets mit rückgeführten vorher eingeführten, vom selben Längsstrich herrührenden Impulsen synchron läuft. Sollte eine Mehrzahl Giesslinien auf der selben Bahn vorkommen, wird an den Kondensatoren $C_1$-$C_6$ ein entsprechendes Muster von Spannungen hergestellt und synchron zur Abtastfrequenz $f_s$ umlaufen gelassen. An den Eingang von $A_7$ angelegte Rauschkomponenten haben geringe unmittelbare Wirkung auf die Spannung an $C_1$. Auch neigen die Rauschkomponenten wegen ihrer willkürlichen Phasenbeziehungen zu Abtastfrequenz $f_s$ dazu, über viele Wiederholungen auf Null zu integrieren.

Für ein praktisches System können weit mehr als sechs Kondensatoren erforderlich sein. Es stehen jetzt jedoch Ladungsverschiebeelemente als integrierte Schaltungen mit 512 Kondensatoren in Reihe zur Verfügung. Die Anzahl nutzbringend durchführbarer Wiederholungen ist durch verschiedene Streu- und Übersprechwirkungen begrenzt und kann ca. 100 betragen. Aus diesem Grund ist es vorteilhaft, diese Art Schaltung zur Mittelung des Ganzen in Verbindung mit einem Abtaststrahl zu benutzen, der in Bahnrichtung wie vorher besprochen verlängert ist.

Für diesen Anwendungsbereich geeignete Ladungsverschiebeelemente werden von E. G. & G. Reticon, Sunnyvale, California, U.S.A. hergestellt und in von dieser Firma 1978 veröffentlichter Literatur mit dem Titel « Product Summary : Discrete Time Analog Signal Processing Devices » und Application Notes Nr. 114 mit dem Titel « Charge Transfer Devices for Sampled-Data Processing » beschrieben.

Wie oben erwähnt, kann eine Reihe von M Kondensatoren bis zu M/2 Analogspannungen speichern. So kann eine Vorrichtung mit 512 Kondensatoren Daten für nur 256 Elemente über die Breite einer abgetasteten Bahn summieren oder mitteln. Diese 256 Elemente sind mit mindestens weiteren 256 Elementen verschachtelt, von denen keine Daten angenommen werden, da der Schalter $S_1$ nach Figur 7 zu den Zeitpunkten, zu denen sie abgetastet werden sollten, offen steht. Gemäss einem Merkmal der Erfindung sind jedoch Mittel vorgesehen zur Abtastung einer unterschiedlichen Gruppe Elemente nach jeder Anzahl W von Abtastungen, wobei die Zahl W hoch genug ist, um eine ausreichende Verbesserung im Rauschabstand durch Summierung bzw. Mittelung des Ganzen sicherzustellen. In einer einfachen Ausführungsform ist es nur erforderlich, nach jeweils W Abtastungen die an die Leitungen 35 und 36 in Figur 7 angelegten gegenphasigen Eingangssignale auszutauschen. Damit wird sichergestellt, dass die Zeitsteuerung der Arbeitsgänge der Schalter $S_1$ bis $S_6$ bei fortwährender Synchronisierung mit dem Abtastvorgang umgekehrt wird, so dass nach jeweils W Abtastungen ein alternatives Elementenmuster untersucht wird.

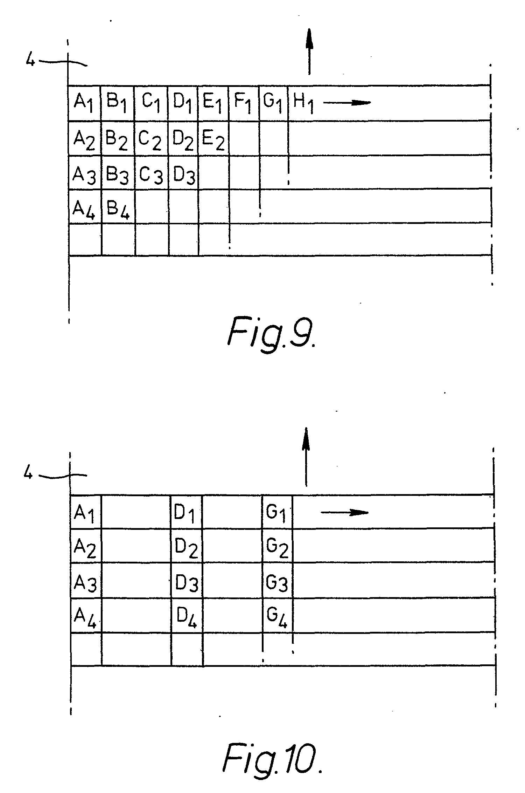

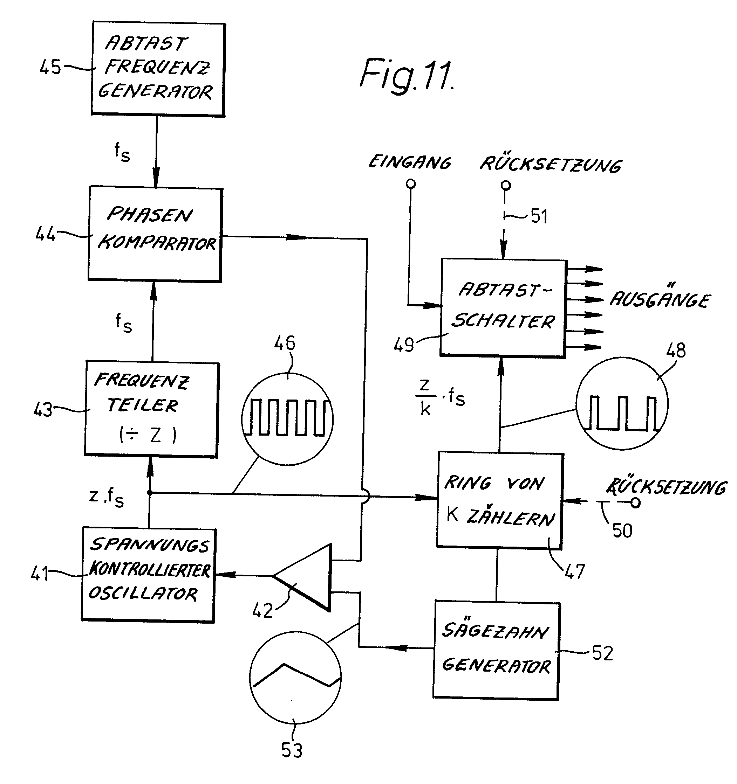

In der Praxis hat man festgestellt, dass, selbst wenn den Leitungen 35 und 36 Steuerwellenformen mit gleichem Impulstastverhältnis zugeführt werden, die Ladungsverschiebe-Laufzeitkette anscheinend auf Eingangssignale anspricht, die nur während eines Teils der Zeit auftreten, während der der Schalter $S_1$ effektiv geschlossen sein sollte. Das bedeutet, dass die über die Bahnbreite untersuchten 256 Elemente schmaler sind, als sonst zu erwarten war, und durch eine grössere Anzahl ähnlicher Elemente getrennt sind, die nicht geprüft werden. Die Erfindung umfasst ein Verfahren zur Nutzung dieser Möglichkeit, und eine entsprechende Ausführungsform wird später unter Bezugnahme auf die Figuren 10 und 11 beschrieben.

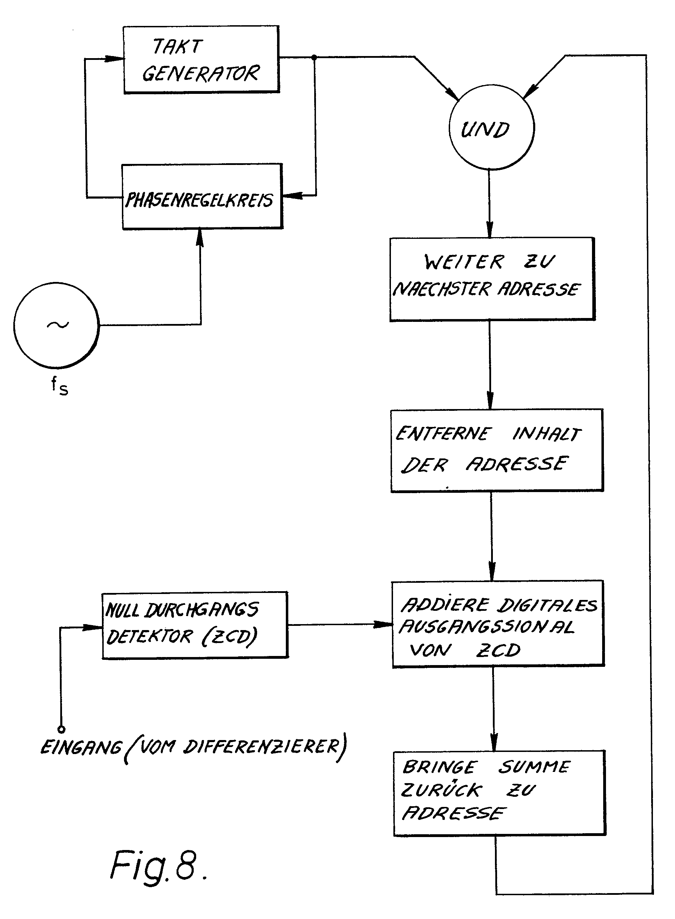

Es wird nun ein weiteres Beispiel einer Schaltung zur Mittelung des Ganzen gegeben, das für den Einsatz in dem im britischen Patent 1 526 375 beschriebenen System geeignet ist und in Figur 8 dargestellt wird. Bei diesem Beispiel wird ein Nulldurchgangdetektor (ZCD) und ein Digitalrechner eingesetzt. Das zu verarbeitende Signal wird an einen Nulldurchgangdetektor angelegt, der es in Digitalform umwandelt, d. h. der Nulldurchgangdetektor liefert eine « 1 », wenn das Eingangssignal positiv ist und eine « 0 », wenn das Eingangssignal negativ ist. Ein zu einer entsprechenden Oberwelle der Abtastfrequenz $f_s$ synchron laufender Taktimpuls bewirkt, dass der Rechner gemäss dem in Figur 8 gezeigten groben Ablaufplan zyklisch arbeitet. Mit jedem Zyklus entnimmt der Rechner einer bestimmten Speicheradresse eine vorher angesammelte Zahl. Das Ausgangssignal des Nulldurchgangdetektors wird zu dieser Zahl hinzuaddiert und die Summe derselben Adresse wieder eingegeben. Der Rechner wartet dann auf einen weiteren Taktimpuls, ehe er zur nächsten Adresse im Speicher vorrückt und den Vorgang wiederholt.

Wenn die Taktfrequenz Z-mal die Abtastfrequenz $f_s$ ist, stellt ein hier nicht gezeigtes Rechnerunterprogramm sicher, dass nach Z solchen Zyklen der Rechner zur ersten der Z zum Sammeln von Daten vom Nulldurchgangdetektor benutzten Adressen zurückkehrt.

Wenn das Eingangssignal zum Nulldurchgangdetektor lediglich zu $f_s$ nicht synchron laufendes willkürliches Rauschen enthält, sammeln die Z Adressen jeweils Zählungen mit einer mittleren Zählgeschwindigkeit, die der halben Abtastfrequenz entspricht. Dies folgt, da die Wahrscheinlichkeit gleich ist, ob ein Ausgangssignal vom Nulldurchgangdetektor im « 1 »- oder im « 0 »-Zustand ist. Zu den der Prüfung einer Giesslinie entsprechenden Zeiten wird aber der Wahrscheinlichkeit ein Vorzugswert beigegeben, so dass beispielsweise eine « 1 » häufiger erzeugt wird als eine « 0 », wenn eine bestimmte Adresse aktualisiert wird. In diesem fall sammelt diese bestimmte Adresse bedeutend mehr Zählungen als die anderen Speicher.

Nach einer vorbestimmten Anzahl Arbeitszyklen gemäss der Logik in Figur 8 untersucht der Rechner die Inhalte der Z Adressen und erstattet Bericht über das Vorhandensein, die Stärke und Lage von Giesslinien entweder direkt oder durch Auslösen des in Figur 5 gezeigten Triggers 25.

Die einzelnen Anwendungsmöglichkeiten des Rechners sind natürlich vielseitig. So kann es zum Beispiel bevorzugt werden, anstelle eine Zählung für « 1 » und keine für « 0 » aufzuaddieren, eine Zählung für « 1 » hinzuzuaddieren und eine Zählung für « 0 » abzuziehen. Diese Verfahrensweise stimmt dann mehr mit den bereits beschriebenen Verfahren überein, indem Rauschkomponenten auf Null integriert werden anstatt auf eine progressiv ansteigende Zählung. Ein Vorteil, der daraus entsteht, dass der Rechner auf diese Weise zum Mitteln des Ganzen benutzt wird, liegt darin, dass jegliche Begrenzung der Anzahl Abtastwellenformen, die gemittelt werden können, beseitigt wird. Da er auf rein digitale Weise arbeitet, unterliegt der Rechnerspeicher keinem Datenverlust durch Energieverlust, z. B. durch Lagungsverlust von Kondensatoren. Der Rechner kann infolgedessen durch Mittelung von über eine sehr grosse Bahnlänge erfassten Daten Längsstrichfehlersignale identifizieren, die um ein Vielfaches kleiner sind als begleitende Rauschkomponenten.

Um mit ausreichender Geschwindigkeit arbeiten zu können, müssen unter Umständen besondere Schnittstellengeräte eingesetzt werden, die es dem Rechner gestatten, Datenblocks zu solchen Zeiten anzunehmen, die an seine eigene interne Zeitsteuerung angepasst sind. Diese als « Speicherdirektzugriff » bekannten Geräte sind Computerfachleuten bekannt und werden hier nicht beschrieben.

Selbst bei Verwendung solcher Kunstgriffe kann es schwierig sein, einen Rechner mit einer solchen Geschwindigkeit zu fahren, dass alle verfügbaren Daten geprüft werden. Ob dies der Fall ist, hängt von der Abtastfrequenz $f_s$ und der Anzahl zu prüfender Punkte entlang dem Prüfweg ab.

In der soweit unter Bezugnahme auf Figur 8 beschriebenen Ausführungsform können Daten für alle gedachten Elementarbereiche auf der Bahn 4 analysiert werden. Man kann unter Bezugnahme auf Figur 9 in Erwägung stellen, dass der Prüfstrahl nacheinander während einer einzelnen Querabtastung die Elementarbereiche $A_1$, $B_1$, $C_1$, $D_1$, $E_1$, $F_1$, $G_1$, $H_1$ usw. untersucht. Bei der nächsten Abtastung ist die Bahn um eine Strecke vorgerückt, die gleich der Länge des Querschnittes des Prüfstrahls ist. Der Prüfstrahl untersucht daher die Elementarbereiche $A_2$, $B_2$, $C_2$, $D_2$, $E_2$ usw. und bei der darauffolgenden Untersuchung die Bereiche $A_3$, $B_3$, $C_3$, $D_3$, usw.

Wie bereits beschrieben wird die Mittelung des Ganzen für die Bereiche $A_1$, $A_2$, $A_3$, $A_4$ ... gleichzeitig mit getrennter Mittelung des Ganzen für Bereiche $B_1$, $B_2$, $B_3$, $B_4$ ... und für jede weitere mit den Buchstaben C, D, E, F, G, H, und so weiter bezeichnete Spalte ausgeführt.

Wenn Giesslinien von einer Breite von nur 0,5 mm in einer 1,5 m breiten Bahn gefunden werden sollen, scheinen 3 000 gleichzeitig durchgeführte Gänge der Mittelung des Gesamten notwendig zu sein. Massnahmen dafür würden eine unwirtschaftlich grosse Ausrüstung erfordern, und es wird nun eine alternative Ausrüstungsform beschrieben, die sich des Verfahrens der vorliegenden Erfindung bedient.

In Figur 10 werden die Photozellensignale so abgetastet, dass Informationen nur für die Elementarbereiche $A_1$, $D_1$, $G_1$ usw. bei der ersten gezeigten Querprüfung gesammelt werden. Bei nachfolgenden Prüfungen werden Informationen an im wesentlichen denselben Stellen entlang dem Abtastweg gesammelt, so dass Mittelung des Ganzen an Daten von den Bereichen $A_1$, $A_2$, $A_3$, $A_4$, ... und (getrennt) an Daten von den Bereichen $D_1$, $D_2$, $D_3$, $D_4$, ... und $G_1$, $G_2$, $G_3$, $G_4$, ... durchgeführt werden kann. Da in Figur 10 nur jeder dritte Elementarbereich abgetastet wird, benötigt diese Anordnung nur ein Drittel so viele gleichzeitige Gänge der Mittelung des Ganzen wie die in Figur 9 gezeigte Anordnung. Dadurch wird es möglich, die Komplexität der erforderlichen Ausrüstung entsprechend zu reduzieren oder die Geschwindigkeit herabzusetzen, mit der der Rechner für eine Echtzeitanalyse der Daten arbeiten muss.

Mit der in Figur 10 gezeigten Anordnung würde allerdings keine vollständig zwischen zwei benachbarten Spalten der abgetasteten Bereiche liegende Giesslinie erfasst werden. So würde beispielsweise eine entlang der Spalte B bzw. Spalte C liegende Giesslinie solange nicht erfasst werden, wie nur die Spalten A, D, G usw. abgetastet werden. Um diese Begrenzung zu überwinden, ist es erforderlich, die Abtastlage zyklisch so zu verschieben, dass alternative mögliche Lagen einer Giesslinie untersucht werden. So würde nach Mittelung des Ganzen der Daten von genügend Abtastungen mit dem Abtastmuster A, D, G usw. nach Figur 10 das Abtastmuster auf B, E, H usw. für weitere Mittelung des Ganzen abgeändert werden. Danach kann der gesamte Zyklus von Arbeitsgängen wiederholt werden.

Während die Erfindung eine nützliche Herabsetzung der Anzahl Datenspeicherelemente vorsieht, die zur Erkennung einer schmalen, willkürlich angeordneten Giesslinie erforderlich sind, ist im erfindungsgemässen Verfahren eine entsprechende Erhöhung der Gesamtzahl von Abtastungen mit einbegriffen, die zur Untersuchung der Bahn auf einen Strich bzw. Striche in allen möglichen Lagen nötig sind. Demzufolge sind stark reduzierte Abtastdichten allgemein nicht attraktiv, obgleich die Figur 10 eine Ausführungsform zeigt, in der bei einer jeden Abtastung jedes dritte Element untersucht wird. In manchen Anwendungsbereichen mag sehr wohl jedes vierte oder jedes fünfte Element untersucht werden. Es ist jedoch unwahrscheinlich, dass in einer Abtastung, die weniger oft als jedes sechzehnte Element stattfindet, ein Vorteil gefunden wird, da die gesamte Bahnprüfarbeit dann 16-mal so lang wie normal üblich dauern würde, wobei dieser normale Brauch darauf beruht, dass jedes Element bei jeder Abtastung abgetastet wird.

Das Fortschreiten des Abtastmusters von einer Phasenbeziehung zur Abtastfrequenz zu einer anderen kann wie oben beschrieben schrittweise stattfinden. Als Alternative kann das Fortschreiten stufenlos durchgeführt werden, vorausgesetzt, dass die Phasenbeziehung langsam genug verändert wird. Ein ausreichend langsames Fortschreiten ist ein solches, bei dem die Phasenbeziehung um das Äquivalent der halben Breite eines Elementarbereichs während der Anzahl Abtastungen verändert wird, über die zum Heraustrennen des Giessliniensignals aus dem Begleitrauschen eine Mittelung des Ganzen notwendig ist.

In Figur 11 wird eine schematische Darstellung einer Vorrichtung zur Realisierung der unter Bezugnahme auf Figur 10 beschriebenen Ausführungsform gezeigt. In Figur 11 arbeitet der Hilfsoszillator 41 mit einer Frequenz, die durch die an seinem Eingang durch den Verstärker 42 angelegte Spannung gesteuert wird. Das Ausgangssignal des Oszillators 41 wird in seiner Frequenz im Frequenzteiler 43 durch einen ganzzahligen Faktor Z geteilt. Im Normalbetrieb ist das Ergebnis dieser Frequenzteilung ein Ausgangssignal mit der Abtastfrequenz $f_s$. Im Phasenvergleicher 44 werden die Phasen der Ausgangssignale des Frequenzteilers 43 und des Abtastfrequenzgenerators 45 verglichen, die beide die Frequenz $f_s$ haben. Der Phasenvergleicher liefert eine Ausgangsspannung, die dem einen Eingang des Verstärkers 42 zugeführt wird und durch die die Ausgangsspannung zum Oszillator 41 in einer

Richtung eingestellt wird, die jeder fortschreitenden Phasenabwanderung zwischen den beiden Eingängen zum Phasenvergleicher 44 entgegenwirkt. Die Positionen 42, 41, 43, 44 umfassen daher eine Phasenregelschleife, die bewirkt, dass der Oszillator mit einer Frequenz von Z-mal $f_s$ arbeitet.

Die Ausgangswellenform des Oszillators 41 ist geeigneterweise rechteckig, wie im Nebenbild 46 gezeigt. Diese Wellenform wird einem Ringzähler 47 mit K Stufen zugeführt, der nur einen positiv verlaufenden Impuls abgibt für jeweils K vom Oszillator 41 empfangene Impulse. Das Ausgangssignal des Zählers 47 wird im Nebenbild 48 gezeigt und wird einem Festkörper-Abtastschalter 49 zugeführt, der beispielsweise dem Drehschalter S in Figur 6 entspricht. Während der Zeit, wenn das Ausgangssignal des Zählers 47 positiv ist, kann der Schalter S so betrachtet werden, dass er zu einem der in Figur 6a gezeigten Schalterkontakte eingeschlossen ist. Während das Ausgangssignal des Zählers 47 Null oder negativ ist, kann der Arm des Schalters S als zwischen zwei aufeinanderfolgenden Kontakten liegend betrachtet werden.

Wenn der Oszillator 41 ein Ausgangssignal mit gleichem Impulstastverhältnis abgibt und wenn K = 2 ist, ist der Schalter 49 zu einer Ausgangsleitung hin zu einer Zeit für nur ein Viertel der Gesamtarbeitszeit geschlossen. Mit jedem positiv verlaufenden Ausgangssignal vom Zähler 47 wird der Stromkreis zu einem anderen Ausgang hin geschlossen, wobei mindestens Z/K Ausgänge vorgesehen sind.

Das Eingangssignal zum Schalter 49 ist das bei 29 in Figur 5 gezeigte gefilterte Signal. Die Ausgänge des Schalters 49 können mit Kondensatoren verbunden werden, die den in Figur 6a gezeigten Kondensatoren C entsprechen.

Nach der bisherigen Beschreibung tastet der Schalter S nur Signale ab, die sich auf 1/4 der Z gedachten Elementarbereiche entlang dem Weg des Querabtastens der Bahn beziehen. Das bedeutet, dass, ohne die Ansprechempfindlichkeit für sehr schmale Defekte aufzugeben, die Anzahl der vom Schalter 49 benötigten Ausgänge auf ein Viertel reduziert ist.

Um sicherzustellen, dass der Abtastvorgang bei jeder nachfolgenden Abtastung nach demselben Muster stattfindet, werden den Rücksetzleitungen 50 und 51, die mit dem Zähler 47 und dem Abtastschalter 49 verbunden sind, Synchronisiersignale zugeführt. Die Synchronisiersignale können zum Beispiel durch den Sprung im Photozellenausgangsstrom erzeugt werden, der entsteht, wenn der Abtaststrahl 3 in Figur 1 den Bahnrand a überquert.

Um sicherzustellen, dass keine Giesslinie dem Erfassungsvorgang entgeht, weil sie zwischen Abtastpunkten versteckt ist, führt ein Sägezahngenerator 52 eine sich langsam verändernde Spannung einem zweiten Eingang des Verstärkers 42 zu. Diese sich langsam verändernde Spannung besitzt vorzugsweise eine symmetrische Wellenform, wie bei 53 in Figur 11 dargestellt. Die Grundfrequenz dieser symmetrischen Wellenform kann zum Beispiel einer vollständigen Schwingungsperiode 4K.E Schwingungsperioden des Hilfsoszillators 41 entsprechen, wobei E die Anzahl Datenpunkte darstellt, die im Ganzen gemittelt werden müssen, um ein Signal aus dem Rauschen herauszuheben.

Durch Anlegen der Wellenform 53 an den Verstärker 42 wird die Phase der Eingangssignale zum Vergleicher 44 solange verschoben, bis eine Komplementärwellenform über das Ausgangssignal des Vergleichers 44 überlagert erscheint. Durch geeignete Einstellung der Amplitude der Wellenform 53 erreicht man, dass sich die Phase der Abtastwellenform 48 sehr langsam im Bezug auf das an die Rücksetzleitungen 50 und 51 angelegte Synchronisiersignal verändert. Als Ergebnis werden die Stellungen über die Bahn hinweg, bezüglich derer ber Photozellenausgang durch den Schalter 49 abgetastet wird, fortschreitend so geändert, dass alle möglichen Lagen für eine Giesslinie untersucht werden.

Da bei einer bestimmten Abtastung nur (beispielsweise) ein Viertel der Filmbahnbreite untersucht wird, muss eine entsprechend grössere Länge der Bahn untersucht werden, um sicher zu gehen, dass alle vorhandenen Giesslinien erfasst werden.

Obgleich die obige Beschreibung auf eine vom Generator 52 in Figur 11 abgegebene symmetrische Sägezahnwellenform bezogen ist, versteht es sich, dass diese Wellenform nicht symmetrisch zu sein braucht. Sie kann sich auch in ihrer Amplitude auf schrittweise Art verändern, d. h. sie kann eine treppenartige Wellenform sein. Die Wellenform sollte vorzugsweise einen gleichen Wahrscheinlichkeitsgrad für alle ihre Amplitudenwerte zeigen, und die symmetrische Sägezahnwellenform wird aufgrund praktischer Einfachheit und Eignung bevorzugt.

Die unter Bezugnahme auf die Figuren 10 und 12 beschriebene Erfindung hat auch besonders Bezug genommen auf das Verfahren zum Abtasten eines Signals, das in Figur 6a gezeigt wird. Es versteht sich jedoch, dass es bei Verwendung eines Abtastschalters mit nur einem einzigen Ausgang möglich ist, das Prinzip der zyklisch phasenmodulierten Abtastung auch auf unter Bezugnahme auf die Figuren 7 und 8 beschriebene Ausführungsformen anzuwenden. In diesen Fällen würde der Abtastschalter dem Eingang zu der in dem entsprechenden Diagramm gezeigten Schaltung vorgeschaltet sein.

Es ist daher ein Verfahren entwickelt worden, das vom oben beschriebenen Stand der Technik abweicht und bei dem elektronische Gatter des Standes der Technik eingesetzt werden, um einen Teil der über die Bahnbreite zur Verfügung stehenden Informationen auszuschliessen, und Zählkreise werden dazu angewandt, Gruppen von Daten zu unterdrücken, die entlang der Bahnlänge erfasst worden sind, aber nicht vorbestimmte Anzahlen aufeinanderfolgender

Zählungen hergeben.

## Ansprüche

1. Verfahren zur Erkennung von Giesslinien auf einer beschichteten Trägerbahn, bei dem die Bahn an einer Prüfstelle vorbeigeführt und dort laufend längs sich im wesentlichen quer zur Fortbewegungsrichtung erstreckenden Pfaden zeilenweise z. B. fotoelektrisch abgetastet und dabei in jedem Zeilen-Abtastpunkt ein von der Stärke der Beschichtung auf der Trägerbahn abhängiges elektrisches Abtastsignal erzeugt wird, bei dem die Abtastsignale von jeweils einer vorgegebenen Anzahl von Zeilenabtastpunkten, die in jeweils in Bewegungsrichtung der Bahn verlaufenden Abtastspuren aufeinanderfolgen, akkumuliert und die dabei für jede Abtastspur getrennt gebildeten akkumulierten Abtastsignale einem Schwellenwertvergleich unterzogen werden, wobei bei Ueberschreitung eines vorgegebenen Schwellenwerts durch eines oder mehrere der akkumulierten Abtastsignale das Vorhandensein einer bzw. mehrer Giesslinien signalisiert wird, dadurch gekennzeichnet, dass die akkumulierten Abtastsignale abwechslungsweise für jeweils eine andere von wenigstens zwei Gruppen von Abtastspuren gebildet werden, wobei diese Gruppen jeweils unterschiedliche Zeilenabtastpunkte umfassen.

2. Verfahren nach Anspruch 1, dadurch gekennzeichnet, dass die Abtastsignale der jeweils vorgegebenen Anzahl von Zeilenabtastpunkten, die in jeweils in Bewegungsrichtung der Bahn verlaufenden Abtastpuren aufeinanderfolgen, gemittelt werden.

3. Verfahren nach Anspruch 1 oder 2, dadurch gekennzeichnet, dass die zu einer Gruppe gehörenden Abtastspuren äquidistant über die Breite der Bahn angeordnet sind.

4. Verfahren nach einem der Ansprüche 1-3, dadurch gekennzeichnet, dass mindestens 3 und nicht mehr als 16 Gruppen von Abtastspuren vorgesehen sind.

5. Verfahren nach einem der vorangehenden Ansprüche, dadurch gekennzeichnet, dass der Uebergang von einer Abtastspurengruppe zur anderen kontinuierlich erfolgt.

6. Verfahren nach einem der vorangehenden Ansprüche, dadurch gekennzeichnet, dass zur Bildung der akkumulierten bzw. gemittelten Abtastsignale die Abtastsignale, die bei jeder Abtastung längs eines Abtastpfads von den einzelnen Zeilen-Abtastpunkten in den zur jeweiligen Spurengruppe gehörigen Abtastspuren erhalten werden, pro Abtastspur jeweils einem eigenen Speicherkondensator zugeführt werden.

7. Verfahren nach einem der Ansprüche 1-5, dadurch gekennzeichnet, dass die Bildung der akkumulierten bzw. gemittelten Abtastsignale mittels einer rückgekoppelten ladungsgekoppelten Laufzeitkette (A1-A6, C1-C6, S1-S6) erfolgt, die mit der Abtastung der Trägerbahn (4) synchronisiert ist und der die einzelnen Abtastsignale seriell zugeführt werden.

8. Verfahren nach einem der Ansprüche 1-5, dadurch gekennzeichnet, dass die Bildung der akkumulierten bzw. gemittelten Abtastsignale auf digitalem Wege erfolgt.

9. Vorrichtung zur Erkennung von Giesslinien auf einer beschichteten Trägerbahn mit einer z. B. fotoelektrischen Abtasteinrichtung (1, 2, 3, 5 ; 21) zur zeilenweisen Abtastung der an ihr vorbeigeführten Trägerbahn (4) entlang sich im wesentlichen quer zur Fortbewegungsrichtung der Bahn erstreckenden Abtastpfaden (6-6''') und zur Erzeugung von elektrischen Abtastsignalen, die von der Stärke der Beschichtung der Trägerbahn in den einzelnen Zeilenabtastpunkten abhängen, einer Akkumulatorschaltung (24 ; C ; A1-A7, C1-C6) zur Akkumulierung der Abtastsignale von jeweils korrespondierenden Zeilenabtastpunkten einer vorgegebenen Anzahl von in Bewegungsrichtung der Trägerbahn (4) aufeinanderfolgenden Abtastpfaden (6-6''') in getrennten Kanälen (C ; C1-C6), einer Vergleichsschaltung (25) zum Vergleich der in jeweils einem der Kanäle akkumulierten Abtastsignale mit einem Schwellenwert und zur Signalisierung einer Giesslinie bei Ueberschreitung des Schwellenwerts, gekennzeichnet durch eine zwischen der Abtasteinrichtung (1, 2, 3, 5 ; 21) und der Akkumulatorschaltung (24 ; C ; A1-A7, C1-C6) angeordnete Auswahlschaltung (22 ; S ; S1-S6 ; 49) zur Auswahl der Abtastsignale von vorgegebenen Zeilenabtastpunkten in den Abtastpfaden, eine Steuerschaltung (26 ; 41-47, 52) zur Veranlassung einer wechselweisen Aktivierung der Auswahlschaltung (22 ; S ; S1-S6 ; 49) für die Abtastsignale von wenigstens zwei unterschiedlichen Sätzen von vorgegebenen Zeilenabtastpunkten, wobei der Uebergang von einem auf den nächstfolgenden Satz jeweils mit Beendigung der getrennten Akkumulierung der Abtastsignale aller jeweils korrespondierenden Zeilenabtastpunkte eines Satzes erfolgt.

10. Vorrichtung nach Anspruch 9, dadurch gekennzeichnet, dass die Akkumulatorschaltung (24) den Mittelwert der ihr zugeführten Abtastsignale bildet.

11. Vorrichtung nach Anspruch 9 oder 10, dadurch gekennzeichnet, dass die Steuerschaltung (26 ; 41-47, 52) zur kontinuierlichen oder sprunghaften Steuerung des Uebergangs von einem auf den nächstfolgenden Satz ausgebildet ist.

12. Vorrichtung nach Anspruch 11, dadurch gekennzeichnet, dass die Auswahlschaltung und die Akkumulatorschaltung durch eine zu einem geschlossenen Ring rückgekoppelte, phasenstarr mit der Abtasteinrichtung (1, 2, 3, 5) getaktete ladungsgekoppelte Laufzeitkette ($A_1$-$A_6$, $C_1$-$C_6$, $S_1$-$S_6$) gebildet sind.

13. Vorrichtung nach Anspruch 11, dadurch gekennzeichnet, dass die Auswahlschaltung und die Akkumulatorschaltung einen Analog-Digitalwandler (ZCD), vorzugsweise einen Nulldurchgangsdetektor, und eine digital arbeitende, mit der Abtasteinrichtung (1, 2, 3, 5) phasenstarr gekoppelte Speichereinrichtung zur getrennten Speicherung und Akkumulation der digitalisierten Abtastsignale aus den einzelnen Punkten des momentanen Abtastsatzes umfassen.

14. Vorrichtung nach einem der Ansprüche 11-13, dadurch gekennzeichnet, dass die Steuerschaltung einen phasengekoppelten Regelkreis (41-44), der einen phasenstarr mit der Abtasteinrichtung (1, 2, 3, 5) gekoppelten Schaltakt erzeugt, und eine Schaltung (52) zur periodischen Aenderung der Phasenlage zwischen der Abtasteinrichtung und dem Schaltakt umfasst.

## Claims

1. Method for the detection of downlines on a coated carrier web, in which the web is moved past an inspection station and is, in the Latter, continuously scanned Line-by-line, for example photoelectrically, along paths which run essentially transversely to the direction of forward movement, and an electrical scanning signal depending on the thickness of the coating on the carrier web is thus generated at each line-scanning point, and in which the scanning signals from a given number of line-scanning points in each case, which succeed one another in each of scanning tracks running in the direction of movement of the web, are accumulated and the accumulated scanning signals, thus formed separately for each scanning track, are subjected to a threshold value comparison, the presence of one or more downlines being signalled when a given threshold value is exceeded by one or more of the accumulated scanning signals, characterised in that the accumulated scanning signals are formed alternately for the other of at least two groups of scanning tracks in each case, each of these groups comprising different line-scanning points.

2. Method according to claim 1, characterised in that the scanning signals from each given number of line-scanning points which succeed one another in each scanning track running in the direction of movement of the web, are averaged.

3. Method according to claim 1 or 2, characterised in that the scanning tracks belonging to one group are arranged at equal distances across the width of the web.

4. Method according to one of claims 1-3, characterised in that at least 3 and not more than 16 groups of scanning tracks are provided.

5. Method according to one of the preceding claims, characterised in that the transition from one group of scanning tracks to another takes place continuously.

6. Method according to one of the preceding claims, characterised in that, for the formation of the accumulated or averaged scanning signals, the scanning signals obtained during each scan along a scanning path from the individual line-scanning points in the scanning tracks belonging to the particular group of tracks, are fed to a separate storage capacitor for each scanning track.

7. Method according to one of claims 1-5, characterised in that the formation of the accumulated or averaged scanning signals is carried out by means of a coupledback, charge-coupled delay line (A1-A6, C1-C6, S1-S6) which is synchronised with the scanning of the carrier web (4) and to which the individual scanning signals are fed serially.

8. Method according to one of claims 1-5, characterised in that the formation of the accumulated or averaged scanning signals is carried out by digital means.

9. Apparatus for the detection of downlines on a coated carrier web, having a, for example, photoelectric scanning device (1, 2, 3, 5 ; 21) for the line-by-line scanning of the carrier web (4), being moved past the device, along scanning paths (6-6''') running essentially transversely to the direction of forward movement of the web and for generating electrical scanning signals depending on the thickness of the coating of the carrier web at the individual line-scanning points, an accumulator circuit (24 ; C ; A1-A7, C1-C6) for accumulating the scanning signals from corresponding line-scanning points in each case of a given number of scanning paths (6-6'''), which succeed one another in the direction of movement of the carrier web (4), in separate channels (C ; C1-C6), a comparator circuit (25) for comparing the scanning signals accumulated in one of the channels in each case with a threshold value and for signalling a downline when the threshold value is exceeded, characterised by a selection circuit (22 ; S ; S1-S6 ; 49), located between the scanning device (1, 2, 3, 5 ; 21) and the accumulator circuit (24 ; C ; A1-A7, C1-C6), for selecting the scanning signals from given line-scanning points in the scanning paths, and a control circuit (26 ; 41-47, 52) for initiating an alternating activation of the selection circuit (22 ; S ; S1-S6 ; 49) for the scanning signals from at least two different sets of given line-scanning points, the transition from one set to the next set taking place in each case at the end of the separate accumulation of the scanning signals from all the corresponding line-scanning points in a particular set.

10. Apparatus according to claim 9, characterised in that the accumulator circuit (24) forms the average value of the scanning signals fed thereto.

11. Apparatus according to claim 9 or 10, characterised in that the control circuit (26 ; 41-47, 52) is designed for continuous or stepwise control of the transition from one set to the next.

12. Apparatus according to claim 11, characterised in that the selection circuit and the accumulator circuit are formed by a cyclically operated charge-coupled delay line (A1-A6, C1-C6, S1-S6) coupled back to give a closed ring in fixed phase relationship with the scanning device (1, 2, 3, 5).

13. Apparatus according to claim 11, characterised in that the selection circuit and the accumulator circuit comprise an analog/digital converter (ZCD), preferably a zero voltage detector, and a digitally working storage device which is coupled in a fixed phase relationship to the scanning device (1, 2, 3, 5), for the separate storage and accumulation of the digitalised scanning signals from the individual points of the set being scanned at the time.

14. Apparatus according to one of claims 11-13, characterised in that the control circuit comprises a phase-coupled regulating circuit (41-44) which generates a switching action coupled in fixed phase relationship to the scanning device (1, 2, 3, 5), and a circuit (52) for periodically changing the phase position between the scanning device and the switching action.

## Revendications

1. Procédé de détermination de défauts allongés sur une bande support revêtue, selon lequel la bande est amenée à un poste de contrôle et y est explorée par exemple photoélectriquement le long de trajets en lignes essentiellement perpendiculaires à la direction du mouvement d'avance, de manière à produire, pour chaque point d'exploration en ligne, un signal électrique d'exploration dépendant de l'épaisseur du revêtement sur la bande support, selon lequel les signaux d'exploration d'un nombre prédéterminé de points d'exploration en ligne qui se succèdent en des pistes d'exploration s'étendant chacune dans la direction du mouvement de la bande, sont accumulés en formant ainsi pour chaque piste d'exploration des signaux d'exploration cumulés, formés séparément et soumis à une comparaison avec une valeur seuil afin que la présence d'un ou plusieurs défauts allongés soit signalée au dépassement d'une valeur seuil prédéterminée par un ou plusieurs signaux d'exploration cumulés, caractérisé en ce que les signaux d'exploration cumulés sont formés alternativement chacun pour un autre d'au moins deux groupes de pistes d'exploration, ces groupes comprenant chacun des points d'exploration en lignes différents.

2. Procédé selon la revendication 1, caractérisé en ce que la moyenne est faite des signaux d'exploration de chaque nombre prédéterminé de points d'exploration en ligne qui se succèdent en des pistes d'exploration dirigées chacune dans la direction du mouvement de la bande.

3. Procédé selon la revendication 1 ou 2, caractérisé en ce que les pistes d'exploration appartenant à un groupe sont équidistantes suivant la largeur de la bande.

4. Procédé selon l'une des revendications 1-3, caractérisé en ce qu'au moins trois et pas plus de seize groupes de pistes d'exploration sont prévus.

5. Procédé selon l'une des revendications précédentes, caractérisé en ce que le passage d'un groupe de pistes d'exploration à un autre se fait de façon continue.

6. Procédé selon l'une des revendications précédentes, caractérisé en ce que, pour former l'accumulation ou la moyenne des signaux d'exploration, les signaux d'exploration qui sont reçus à chaque exploration le long d'un trajet d'exploration des points individuels d'exploration en ligne des pistes d'exploration appartenant à chaque groupe de pistes sont appliquées à un condensateur d'emmagasinage propre à chaque piste d'exploration.

7. Procédé selon l'une des revendications 1-5, caractérisé en ce que la formation de l'accumulation ou de la moyenne des signaux d'exploration est faite au moyen d'une chaîne à temps de transit (A1-A6, C1-C6, S1-S6) à couplage de charge avec connexion en retour qui est synchronisée avec l'exploration de la bande support (4) et à laquelle les signaux individuels d'exploration sont appliqués en série.

8. Procédé selon l'une des revendications 1-5, caractérisé en ce que l'accumulation ou la moyenne des signaux d'exploration est faite par des moyens numériques.

9. Dispositif de détermination de défauts allongés sur une bande support revêtue avec un dispositif d'exploration (1, 2, 3, 5 ; 21) par exemple photoélectrique pour explorer en ligne la bande support (4) qui lui est amenée le long de trajets d'exploration (6, 6''') essentiellement perpendiculaires à la direction du mouvement d'avance de la bande, et pour produire des signaux électriques d'exploration qui dépendent de l'épaisseur du revêtement de la bande support en des points individuels d'exploration en lignes, un circuit d'accumulateur (24 ; C ; A1-A7, C1-C6) pour accumuler dans des canaux séparés (C, C1-C6) les signaux d'exploration de chacun des points d'exploration en ligne correspondants d'un nombre prédéterminé de trajets d'exploration (6, 6''') se succédant dans la direction du mouvement de la bande support (4), un circuit comparateur (25) pour comparer avec une valeur seuil les signaux d'exploration accumulés chacun de l'un des canaux et pour signaler un défaut allongé au dépassement de la valeur seuil, caractérisé en ce qu'il comporte un circuit de sélection (22 ; S ; S1-S6 ; 49) disposé entre le dispositif d'exploration (1, 2, 3, 5 ; 21) et le circuit d'accumulateur (24 ; C ; A1-A7, C1-C6) et destiné à sélectionner les signaux d'exploration de points prédéterminés d'exploration en ligne dans les trajets d'exploration, un circuit de commande (26 ; 41-47, 52) destiné à provoquer une excitation alternée du circuit de sélection (22 ; S, S1 ; S6 ; 49) pour les signaux d'exploration d'au moins deux groupes différents prédéterminés d'exploration en ligne, le passage d'un groupe au suivant se faisant à la fin de l'accumulation séparée des signaux d'exploration de tous les points correspondants d'exploration en ligne d'un groupe.

10. Dispositif selon la revendication 9, caractérisé en ce que le circuit d'accumulateur (24) forme la valeur moyenne des signaux d'exploration qui lui sont appliqués.

11. Dispositif selon la revendication 9 ou 10, caractérisé en ce que le circuit de commande (26 ; 41-47, 52) est réalisé pour une commande continue ou pas à pas du passage d'un groupe au suivant.

12. Dispositif selon la revendication 11, caractérisé en ce que le circuit de sélection et le circuit d'accumulateur sont constitués par une chaîne à temps de transit (A1-A6, C1-C6, S1-S6) à couplage de charge commandée par horloge, à réaction en un anneau fermé et verrouillé en phase avec le dispositif d'exploration.

13. Dispositif selon la revendication 1, caractérisé en ce que le circuit de sélection et le circuit d'accumulateurs comprennent un convertisseur analogique-numérique (ZCD), de préférence un détecteur de passage par zéro et un dispositif à mémoire à fonctionnement numérique couplé en verrouillage de phase avec le dispositif d'exploration (1, 2, 3, 5), destiné à mémoriser et à accumuler séparément les signaux d'exploration numérisés des points individuels des groupes d'exploration momentanés.

14. Dispositif selon l'une des revendications 11-13, caractérisé en ce que le circuit de commande comporte un circuit régulateur (41-44) à couplage de phase qui produit un signal d'horloge verrouillé en phase avec le dispositif d'exploration (1, 2, 3, 5) et un circuit (52) de modification périodique de la position de phase entre le dispositif d'exploration et le signal d'horloge.

*Fig. 1.*

*Fig. 2a.*

*Fig. 2b.*

*Fig. 2c.*

*Fig. 2d.*

Fig.3a.

Fig.3b.

Fig.3c.

Fig.3d.

Fig.3e.

Fig.3f.

Fig.3g.

Fig.4a.

Fig.4b.

Fig.4c.

Fig.4d.

Fig.5.

Fig. 6a.

Fig. 6b.

Fig. 7.

EINGANG

0 030 520

Fig.8.

| $A_1$ | $B_1$ | $C_1$ | $D_1$ | $E_1$ | $F_1$ | $G_1$ | $H_1$ → |
|-------|-------|-------|-------|-------|-------|-------|---------|
| $A_2$ | $B_2$ | $C_2$ | $D_2$ | $E_2$ | | | |
| $A_3$ | $B_3$ | $C_3$ | $D_3$ | | | | |
| $A_4$ | $B_4$ | | | | | | |
| | | | | | | | |

*Fig.9.*

| $A_1$ | | $D_1$ | | $G_1$ | → |
|-------|--|-------|--|-------|---|
| $A_2$ | | $D_2$ | | $G_2$ | |
| $A_3$ | | $D_3$ | | $G_3$ | |
| $A_4$ | | $D_4$ | | $G_4$ | |
| | | | | | |

*Fig.10.*

7

Fig.11.